# EUROPÄISCHE PATENTSCHRIFT

(11) **EP 1 121 847 B1**
(45) Veröffentlichungstag und Bekanntmachung des Hinweises auf die Patenterteilung: **08.12.2004**
(21) Anmeldenummer: 99957907.1
(22) Anmeldetag: 12.10.1999
(51) Int. Cl.: H05K 13/04

(54) **HALTERUNG**
HOLDER
DISPOSITIF DE FIXATION

(30) Priorität: 16.10.1998 DE 19847843
(43) Veröffentlichungstag der Anmeldung: 08.08.2001
(73) Patentinhaber: Infineon Technologies AG, 81669 München (DE)
(72) Erfinder: SCHULZ, Klaus, D-12309 Berlin (DE); STOCKHAUS, Andreas, D-14199 Berlin (DE)
(74) Vertreter: Müller, Wolfram Hubertus, Dipl.-Phys.
(86) Internationale Anmeldenummer: PCT/DE1999/003310
(87) Internationale Veröffentlichungsnummer: WO 2000/024237

(56) Entgegenhaltungen:
- US-A- 4 131 982

## Beschreibung

Die Erfindung betrifft eine Halterung zur lösbaren Fixierung eines Bauteils in einer betriebsbereiten Endposition. Eine. derartige Halterung ist beispielsweise in der älteren Deutschen Patentanmeldung derselben Anmelderin mit dem amtlichen Aktenzeichen 198 43 708.0 beschrieben und dient zur lösbaren Montage bzw. Befestigung eines elektronischen Bauteils, beispielsweise eines elektrooptischen Transceivers, auf einem Träger (z.B. einer Leiterplatte). Derartige Halterungen können insbesondere bei vergleichsweise schwer zugänglichen Montageorten für Bauteile und/oder bei Bauteilen, die einfach montiert bzw. demontiert werden sollen, eingesetzt werden.

Bei der Montage von Bauteilen ist es für den Anwender wünschenswert, das Erreichen der betriebsbereiten Endposition des Bauteils deutlich vermittelt zu bekommen. Dies kann beispielsweise dann von besonderer Bedeutung sein, wenn ungeübtes Personal mit der Montage betraut ist oder es bei der Montage auf das zuverlässige Erreichen der Endposition erheblich ankommt; das kann z.B. dann der Fall sein, wenn erst mit Erreichung der Endposition eine korrekte elektrische Kontaktierung des Bauteils sichergestellt ist.

Vor diesem Hintergrund besteht die Aufgabe der vorliegenden Erfindung in der Schaffung einer Halterung zur lösbaren Fixierung eines Bauteils in einer betriebsbereiten Endposition mit verbesserten anwenderfreundlichen Eigenschaften, indem die Halterung das Erreichen der Endposition für den jeweiligen Anwender erkennbar deutlich signalisiert und/oder bei der Demontage des Bauteils unterstützend wirkt.

Diese Aufgabe wird erfindungsgemäß gelöst durch eine Halterung zur lösbaren Fixierung eines Bauteils in einer betriebsbereiten Endposition, mit einer Oberseite, über die hinweg das Bauteil in einer Montagerichtung in die Endposition bewegt wird, und mit einer Auswurfeinrichtung, die zumindest eine Feder umfaßt, die auf das Bauteil in der betriebsbereiten Endposition eine Federkraft entgegen der Montagerichtung ausübt.

Ein erster wesentlicher Aspekt der Erfindung besteht darin, daß während des Montagevorgangs bei der Bewegung des Bauteils in Montagerichtung in die Endposition die Feder der Auswurfeinrichtung vorgespannt wird; je nach Federkonstante und Federweg signalisiert die zu überwindende, zunehmende Federkraft damit die Annäherung an die Endposition. Ein weiterer wesentlicher Aspekt der Erfindung besteht darin, daß die in der Endposition vorgespannte Feder auf das Bauteil eine entgegen der Montagerichtung wirkende Kraft ausübt, die bei der Demontage und Entnahme des Bauteils unterstützend wirkt. Ein besondere Vorteil besteht dabei darin, daß die Federkraft das Bauteil durchaus über eine bemerkenswerte Wegstrecke auswerfen kann. Damit wird das Bauteil beispielsweise aus einer an sich schwer zugänglichen Endposition bedarfsweise in eine Position bewegt, in der das Bauteil bequemer greifbar ist.

Ein weiterer wesentlicher Vorteil der Erfindung besteht darin, daß die Auswurfeinrichtung als Bestandteil der Halterung in ihrer Position gegenüber der Halterung bereits hochpräzise vormontiert werden kann. Außerdem kann sie eine zusammen mit der Halterung handhabbare Einheit bilden, was sich fertigungstechnisch vorteilhaft auswirkt. Insgesamt zeichnet sich die erfindungsgemäße Halterung trotz ihrer mehreren Funktionalitäten durch einen bemerkenswert einfachen Aufbau aus.

Eine bevorzugte Ausgestaltung der Erfindung besteht darin, daß die Feder im Bereich der Oberseite der Halterung zumindest einen über die Oberseite hervorstehenden Mitnehmer aufweist, der bei der Bewegung des Bauteils in die Endposition mit einem Anschlag an der Bauteilunterseite in Kontakt kommt und die Feder auslenkt. Diese Ausgestaltung erlaubt eine besonders kompakte Konstruktion der Halterung, wobei die Mitnehmer im Bereich der Oberseite angeordnet sind und über der Oberseite verbleiben, so daß kein zusätzlicher Bauraum für die damit erreichte Montage- bzw. Demontageerleichterung erforderlich ist.

Eine hinsichtlich der Federeigenschaften und der dadurch erzeugbaren Federkräfte vorteilhafte Fortbildung der Erfindung sieht vor, daß die Feder zwei voneinander weg gebogene federnde Schenkel hat, deren Enden Mitnehmer aufweisen.

Eine besonders bevorzugte Weiterbildung der Erfindung besteht darin, daß die Feder integral am rückwärtigen Ende einer Zunge ausgebildet ist, die sich entgegen der Montagerichtung unterhalb des Bauteils erstreckt und an ihrem vorderen freien Zungenende ein Verriegelungselement aufweist, das in der Endposition mit einem Verriegelungspartner des Bauteils zusammenwirkt. Damit dient die Halterung einer weiteren Funktion, nämlich der Verriegelungsfunktion zwischen Bauteil und Halterung. Ein wesentlicher Aspekt ist dabei, daß sowohl die hinsichtlich der Verriegelungsfunktion als auch die hinsichtlich der Auswurffunktion maßgebenden Toleranzen von einem einzigen integralen Bauteil realisiert sind. Die relativen geometrischen Entfernungen zwischen den zusammenwirkenden Funktionsflächen können (z.B. zwischen den Mitnehmern und dem Verriegelungselement) dadurch mit höchster reproduzierbarer Genauigkeit hergestellt werden.

Eine besonders platzsparende und insbesondere hinsichtlich einer niedrigen realisierbaren Bauhöhe vorteilhafte Weiterbildung der Erfindung ist dadurch realisiert, daß die Feder in der dem Bauteil abgewandten Unterseite der Halterung aufgenommen ist.

Eine besonders niedrige Bauhöhe läßt sich in diesem Zusammenhang bei einem dennoch bemerkenswerten Federweg dadurch erreichen, daß die Feder aus einem Flachblech gebildet ist.

Eine insbesondere zu elektrischen Abschirmungszwecken vorteilhafte Weiterbildung der Erfindung besteht darin, daß die Feder und ein bauteilseitiger Anschlag für die Feder aus leitendem Material bestehen. Über dem in der Endposition bestehenden physikalischen Kontakt zwischen der Feder und dem Anschlag für die Feder kann somit ein zusätzlicher Kontakt geschaffen werden, der nur in der Endposition wirksam ist. Dieser kann außer zu Abschirmungszwecken z.B. auch zu Kontrollzwecken bezüglich des Erreichens der Endposition dienen.

Ein Ausführungsbeispiel der Erfindung wird nachfolgend anhand einer Zeichnung weiter erläutert; es zeigen in starker Vergrößerung und perspektivischer Ansicht:
- Figur 1: eine Feder,
- Figuren 2 und 3: eine erfindungsgemäße Halterung von der Unterseite bzw. der Oberseite aus betrachtet,
- Figur 4: ein mit der Halterung zu verbindendes Bauteil und
- Figur 5: ein mit der Halterung verbundenes Bauteil in einer betriebsbereiten Endposition.

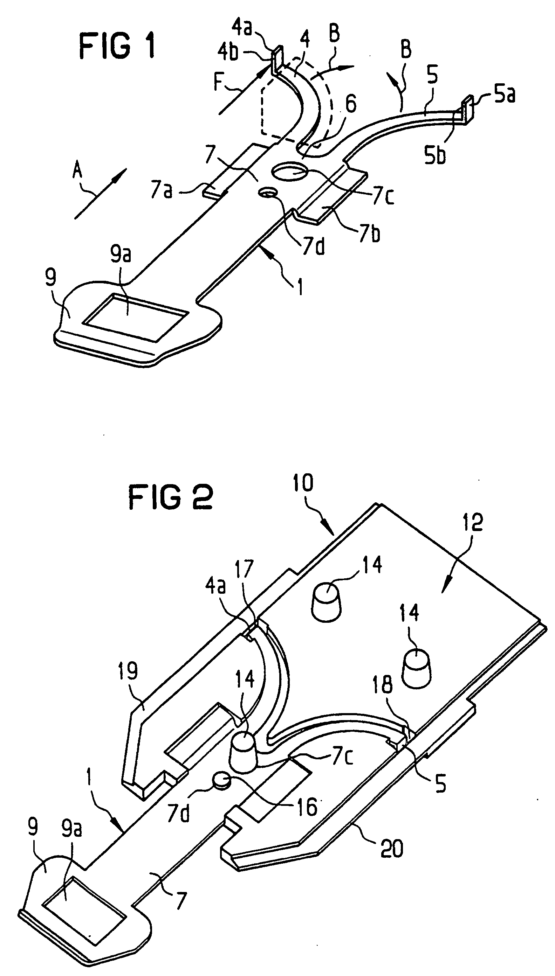

Das in Figur 1 gezeigte und summarisch als federndes Element oder Feder 1 bezeichnete Teil ist aus einem Flachblech ausgeschnitten und hat eine im wesentlichen Y-förmige Gestalt. Die beiden freien Arme der Y-Form sind als federnde, sich voneinander wegerstreckende Schenkel 4, 5 ausgebildet. An den Enden 4a, 5a der Schenkel sind Mitnehmer mit Wirkflächen 4b, 5b angeformt. Die Schenkel 4, 5 laufen am rückwärtigen Ende 6 einer Zunge 7 zusammen. Die Zunge hat im mittleren Bereich niedergeprägte Montage- und Erdungslappen 7a, 7b und erstreckt sich entgegen der mit A bezeichneten und nachfolgend noch näher erläuterten Montagerichtung bis zu einem vorderen Ende 9. Das Ende 9 ist als federnde Verriegelungslasche mit einer Ausnehmung 9a gestaltet. Die bei Kraftbeaufschlagung F z.B. der Wirkfläche 4b zur elastischen, federnden Verformung des Schenkels 4 zur Verfügung stehende Biegezone des Federmaterials ist gestrichelt umrandet.

Figur 2 zeigt eine erfindungsgemäße Halterung 10 im Blick auf ihre Unterseite 12. Die Unterseite hat mehrere Montagezapfen 14, die zur Positionierung der Halterung z.B auf einer Leiterplatte dienen. Dazu durchdringen die Zapfen 14 entsprechende Bohrungen in der in Figur 2 nicht dargestellten Leiterplatte. Ein Zapfen 14 sowie ein Haltestift 16 durchdringen entsprechende Bohrungen 7c, 7d der Zunge 7. In der in Figur 2 gezeigten Position ist die Zunge 7 gegenüber der Darstellung in Figur 1 um ihre Längsachse gewendet. Die Feder 1 ist in ihrer Form entsprechende Ausnehmungen oder Vertiefungen eingelassen, so daß die Bauhöhe der plattenförmigen Halterung trotz integrierter Feder nicht erhöht ist. So läßt sich in der praktischen Realisierung eine Bauhöhe von weniger als 1,5 mm bei einem Federweg von durchaus 0,4 mm realisieren. Die Mitnehmer 4a, 5a durchdringen in der Halterung 10 vorgesehene Durchgangsöffnungen 17, 18. Die Halterung 10 weist an ihren Schmalseiten längs verlaufende Schienen 19, 20 auf, die in nachfolgend noch näher erläuterte Weise von entsprechenden Winkeln eines Bauteilgehäuses hintergriffen werden, die beim Montagevorgang sukzessive mit den Schienen 19, 20 in Eingriff gelangen.

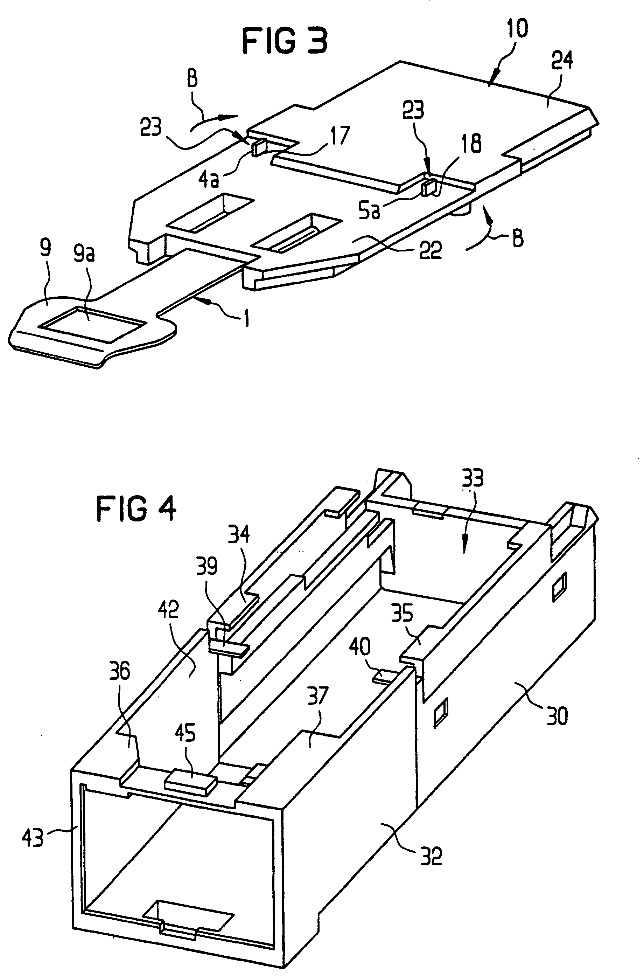

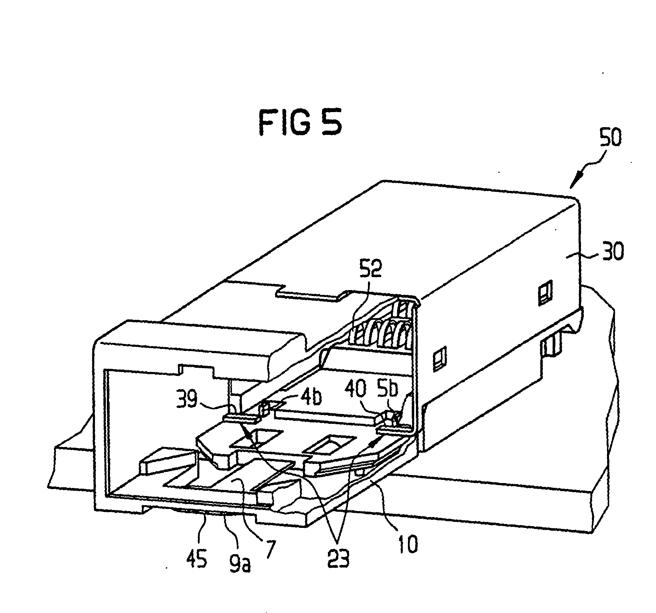

Figur 3 zeigt die in Figur 2 dargestellte Halterung 10 mit Blick auf ihre Oberseite 22. Dabei wird deutlich, daß die Mitnehmer 4a, 5a die Durchgangsöffnungen 17, 18 vollständig durchdringen und damit über die Oberseite 22 überstehen. Das mit der Halterung verbundene Element 1 bildet mit seinen Mitnehmern, die auf ein in die Endposition geführtes Bauteil eine von den ausgelenkten Schenkeln erzeugte Federkraft ausüben, eine Auswurfeinrichtung 23. Kurz hinter den Mitnehmern 4a, 4b schließt sich ein hinteres Plateau 24 der Halterung 10 an, auf dem beispielsweise elektrische Kontakte angeordnet sein können, die mit entsprechenden Kontaktflächen des zu montierenden Bauteils zu elektrischen Kontaktierung zusammenwirken; die Kontakte oder Kontaktleisten können auch hinter dem Plateau angeordnet sein (vgl. Figur 5).

Figur 4 zeigt ein Bauteil 30, das von seinen inneren Komponenten befreit ist, um zur besseren Darstellung den Blick auf für die Erfindung wesentliche mechanische Aspekte freizugeben. Figur 4 zeigt dabei das Gehäuse 32 des Bauteils 30 von der Unterseite 33 her betrachtet.

Neben bereits im Zusammenhang mit der Figur 2 erwähnten Hintergreifungen 34 bis 37 sind nach innen gebogene aufeinander zuweisende Metallaschen 39, 40 erkennbar, die aus einem Abschirmblech 42 freigearbeitet sind. Ferner ist im frontseitigen Bereich 43 des Gehäuses eine Verriegelungsnase 45 vorgesehen, die in der Endposition mit der Ausnehmung 9a des vorderen Zungenendes 9 (Figuren 2 und 3) zusammenwirkt.

Bei der Montage des Bauteils 30 auf der Halterung 10 gelangen zunächst die Hintergreifungen 34 bis 37 mit den Schienen 19, 20 der Halterung in Hintergriff und führen damit die weitere Bewegung des Bauteils. Dabei überstreicht das Bauteil mit seiner Unterseite 33 die Oberseite 22 der Halterung 10 in Montagerichtung A.

Kurz vor Erreichen der in Figur 5 dargestellten Endposition 50 gelangen auch die als Anschläge wirkenden Laschen 39, 40 in Kontakt mit den Mitnehmern 4a, 5a bzw. deren Wirkflächen 4b, 5b der Auswurfeinrichtung 23. Dabei führen die federnden Schenkel 4, 5 eine kreisbogenartige Bewegung aufeinander zu aus, wie durch Pfeile B in den Figuren 1 und 3 angedeutet. Diese Bewegung erzeugt eine wegabhängige Federkraft, die von den Schenkeln 4, 5 auf die Anschläge 39, 40 und damit auf das Bauteil ausgeübt wird. Beim Erreichen der Endposition 50 ruhen nur andeutungsweise dargestellte Kontakte 52 auf korrespondierenden Kontaktflächen auf der Unterseite einer nicht dargestellten Leiterplatte des Bauteils 30.

Figur 5 zeigt ferner andeutungsweise, wie die Verriegelungsnase 45 (Figur 4) in die Ausnehmung 9a der Zunge 7 eingreift und damit das Bauteil 30 in axialer Richtung verriegelt. Die von der Auswurfeinrichtung 23 ausgeübten Kräfte werden damit im Zustand der Endposition von der Zunge 7 aufgenommen. Beim Einführen des Bauteils 30 in die Endposition 50 wird durch den Federweg eine zunehmende Federkraft erzeugt, die der Anwender bei der Montage des Bauteils gut wahrnehmen kann. Damit ist ihm signalisiert, daß das Erreichen der Endposition unmittelbar bevorsteht.

Die in die Halterung 10 integrierte Feder 1 ist als Flachblechteil ausgeführt (Figur 1) und beansprucht dadurch nur eine äußerst geringe Bauhöhe, wobei andererseits durch die Querschnittsorientierung der flachen federnden Schenkel 4, 5 durchaus hohe Federkräfte erzeugt werden können. Diese tragen vorteilhafterweise dazu bei, die von den elektrischen Kontakten 52 auf das Bauteil ausgeübten, der Entnahmebewegung entgegenwirkenden Reibungskräfte zu überwinden. Die individuellen Federkräfte können durch entsprechende Formgebung der Schenkel 4, 5 modifiziert werden. Bei der Demontage des Bauteils wird zunächst die Ausnehmung 9a außer Eingriff von der Nase 45 gebracht, woraufhin das Bauteil aufgrund der Federbeaufschlagung der Laschen 39, 40 durch die Schenkel 4, 5 der Auswurfeinrichtung 23 entgegen der Montagerichtung A nach vorn bewegt wird. Dadurch läßt sich das Bauteil bequem greifen. Ein weiterer vorteilhafter Aspekt der Auswurfeinrichtung besteht darin, daß Bauteile, die die Endposition nicht erreicht haben oder sich aus der Endposition gelöst haben, deutlich hervorstehen.

## Patentansprüche

1. Halterung zur lösbaren Fixierung eines Bauteils (30) in einer betriebsbereiten Endposition (50),
- mit einer Oberseite (22), über die hinweg das Bauteil (30) in einer Montagerichtung (A) in die Endposition (50) bewegt wird, und
- mit einer Auswurfeinrichtung (23), die zumindest eine Feder (1) umfaßt, die auf das Bauteil (30) in der betriebsbereiten Endposition (50) eine Federkraft entgegen der Montagerichtung (A) ausübt.

2. Halterung nach Anspruch 1, wobei
- die Feder (1) im Bereich der Oberseite (22) der Halterung zumindest einen über die Oberseite (22) hervorstehenden Mitnehmer (4a, 5a) aufweist, der bei der Bewegung des Bauteils (30) in die Endposition (50) mit einem Anschlag (39, 40) an der Bauteilunterseite (33) in Kontakt kommt und die Feder (1) auslenkt.

3. Halterung nach Anspruch 1 oder 2, wobei
- die Feder (1) zwei voneinander weg gebogene federnde Schenkel (4, 5) hat, deren Enden Mitnehmer (4a, 5a) aufweisen.

4. Halterung nach Anspruch 1, 2 oder 3, wobei
- die Feder (1) integral am rückwärtigen Ende (6) einer Zunge (7) ausgebildet ist, die sich entgegen der Montagerichtung (A) unterhalb des Bauteils (30) erstreckt und an ihrem vorderen freien Zungenende (9) ein Verriegelungselement (9a) aufweist, das in der Endposition (50) mit einem Verriegelungspartner (45) des Bauteils (30) zusammenwirkt.

5. Halterung nach Anspruch 1, 2, 3 oder 4, wobei
- die Feder (1) in der dem Bauteil (30) abgewandten Unterseite (12) der Halterung (10) aufgenommen ist.

6. Halterung nach Anspruch 1, 2, 3, 4 oder 5, wobei
- die Feder (1) aus einem Flachblech gebildet ist.

7. Halterung nach Anspruch 1, 2, 3, 4, 5 oder 6, wobei
- die Feder (1) und ein bauteilseitiger Anschlag (39, 40) für die Feder (1) aus leitendem Material bestehen.

## Claims

1. Holder for detachably fixing a component (30) in an operational end position (50),
- with an upper side (22), over which the component (30) is moved in a mounting direction (A) into the end position (50), and
- with an ejecting mechanism (23), which comprises at least one spring (1), which exerts a spring force counter to the mounting direction (A) on the component (30) in the operational end position (50).

2. Holder according to Claim 1,
- the spring (1) having in the region of the upper side (22) of the holder at least one catch (4a, 5a), which projects beyond the upper side (22) and, when the component (30) moves into the end position (50), comes into contact with a stop (39, 40) on the underside (33) of the component and deflects the spring (1).

3. Holder according to Claim 1 or 2,
- the spring (1) having two resilient legs (4, 5), which are bent away from each other and the ends of which have catches (4a, 5a).

4. Holder according to Claim 1, 2 or 3,
- the spring (1) being integrally formed on the rear end (6) of a tongue (7), which extends counter to the mounting direction (A) underneath the component (30) and has at its front, free tongue end (9) a locking element (9a), which in the end position (50) interacts with a locking partner (45) of the component (30).

5. Holder according to Claim 1, 2, 3 or 4,
- the spring (1) being accommodated in the underside (12) of the holder (10), facing away. from the component (30).

6. Holder according to Claim 1, 2, 3, 4 or 5,
- the spring (12) being formed from a flat metal sheet.

7. Holder according to Claim 1, 2, 3, 4, 5 or 6,
- the spring (1) and a stop (39, 40) provided on the component for the spring (1) consisting of conductive material.

## Revendications

1. Dispositif de fixation pour immobiliser de manière amovible une pièce (30) en une position (50) d'extrémité prête au fonctionnement,
- comportant une face (22) supérieure sur laquelle la pièce (30) est déplacée dans un dispositif (A) de montage pour venir à la position (50) d'extrémité, et
- comportant un dispositif (23) d'éjection, qui comprend au moins un ressort (1) qui exerce sur la pièce (30) en la position (50) d'extrémité prête au fonctionnement une force élastique à l'encontre du dispositif (A) de montage.

2. Dispositif de fixation suivant la revendication 1, dans lequel
- le ressort (1) comporte dans la région de la face (22) supérieure du dispositif de fixation au moins un toc (4a, 5a) d'entraînement en saillie au dessus de la face (22) supérieure, qui, lorsque la pièce (30) vient à la position (50) d'extrémité, vient en contact avec une butée (39, 40) sur la face (33) inférieure de la pièce et dévie le ressort (1 ).

3. Dispositif de fixation suivant la revendication 1 ou 2, dans lequel
- le ressort (1) comporte deux branches (4, 5) élastiques, incurvées en s'éloignant l'une de l'autre, dont les extrémités comportent les tocs (4a, 5a) d'entraînement.

4. Dispositif de fixation suivant l'une des revendications 1, 2 ou 3, dans lequel
- le ressort (1 ) est réalisé d'une pièce à l'extrémité (6) arrière d'une languette (7) qui s'étend en sens opposé à la direction (A) de montage au-dessous de la pièce (30) et qui comporte à son extrémité (9) de languette libre avant un élément (9a) de verrouillage, qui coopère en la position (50) d'extrémité avec un partenaire (45) de verrouillage de la pièce (30).

5. Dispositif de fixation suivant l'une des revendications 1, 2, 3 ou 4, dans lequel
- le ressort (1) est reçu dans la face (12) inférieure, éloignée de la pièce (30), du dispositif (10) de fixation.

6. Dispositif de fixation suivant l'une des revendications 1, 2, 3, 4 ou 5, dans lequel
- le ressort (1) est formé d'une tôle plate.

7. Dispositif de fixation suivant l'une des revendications 1, 2, 3, 4, 5 ou 6, dans lequel
- le ressort (1) et une butée (39, 40), côté pièce, pour le ressort (1) sont en un matériau conducteur.
